# EUROPÄISCHE PATENTSCHRIFT

(11) **EP 3 926 254 B1**
(45) Veröffentlichungstag und Bekanntmachung des Hinweises auf die Patenterteilung: **01.01.2025**
(21) Anmeldenummer: 21172968.6
(22) Anmeldetag: 10.05.2021
(51) Int. Cl.: H01L 23/427, H01L 23/473, F25B 5/04, F25B 31/00

(54) **KRAFTWÄRMEMASCHINE**
POWER HEATING MACHINE
MACHINE THERMODYNAMIQUE

(30) Priorität: 10.06.2020 DE 102020115492
(43) Veröffentlichungstag der Anmeldung: 22.12.2021
(73) Patentinhaber: ebm-papst Mulfingen GmbH & Co. KG, 74673 Mulfingen (DE)
(72) Erfinder: SCHNEIDER, Alex, 74653 Künzelsau (DE)
(74) Vertreter: Staeger & Sperling Partnerschaftsgesellschaft mbB

(56) Entgegenhaltungen:
- EP-A1- 3 301 379
- WO-A1-2010/034569
- JP-A- 2016 121 843
- US-A1- 2009 092 501

## Beschreibung

Die Erfindung betrifft eine Kraftwärmemaschine mit einer Wärmeübertragungsvorrichtung zur Steigerung des Wirkungsgrades.

Im Stand der Technik sind Kraftwärmemaschinen, also beispielsweise Wärmepumpen und Kältemaschinen, seit langem bekannt. Diese erzeugen unter Einsatz mechanischer Energie und durch einen thermodynamischen Prozess Wärmeenergie, wobei bei einer Wärmepumpe einem Ursprungs- oder Ausgangssystem Wärmeenergie entzogen und einem Zielsystem zugeführt wird.

Bei einer Kältemaschine werden im Wesentlichen lediglich Ausgangs- und Zielsystem miteinander vertauscht, so dass dem Zielsystem Wärme entzogen und dem Ausgangssystem zugeführt wird.

Beim Erzeugen der mechanischen Energie kommt es jedoch meist zu Wärmeverlusten, welche zu einer Verringerung des Wirkungsgrades des Gesamtsystems führen.

Beispielsweise erhitzen sich elektronische Baugruppen oder Bauteile der Kraftwärmemaschine, was nicht nur zu Wärmeverlusten sondern oftmals auch zu einer Überhitzung der Baugruppen oder Bauteile und somit zu einer Reduzierung der Lebensdauer dieser Komponenten führt.

Zudem sind aus den Dokumenten US 2009/092501 A1, JP 2016 121843 A, EP 3 301 379 A1 und WO 2010/034569 A1 jeweils Kraftwärmemaschinen bekannt, welche von ihrer jeweiligen Elektronik abgegebene Wärme ebenfalls auf ein Kältemittel übertragen. Sie offenbaren jeweils eine Kraftwärmemaschine gemäß dem Oberbegriff des Anspruchs 1.

Der Erfindung liegt deshalb die Aufgabe zugrunde, die vorgenannten Nachteile zu überwinden und eine Kraftwärmemaschine bereitzustellen, deren Wirkungsgrad und Lebensdauer gegenüber einer herkömmlichen Kraftwärmemaschine erhöht ist.

Diese Aufgabe wird durch die Merkmalskombination gemäß Patentanspruch 1 gelöst.

Erfindungsgemäß wird eine insbesondere als Wärmepumpe ausgebildete Kraftwärmemaschine mit den Merkmalen des Anspruchs 1 vorgeschlagen, welche grundsätzlich jedoch auch als Kältemaschine ausgebildet sein kann. Die Kraftwärmemaschine weist einen ersten insbesondere als Verdampfer ausgebildeten Wärmetauscher, einen Verdichter, einen zweiten insbesondere als Verflüssiger ausgebildeten Wärmetauscher und eine Drosselvorrichtung auf, wobei diese Komponenten durch eine von einem Kältemittel durchströmten Kältemittelleitung verbunden sind.

Bei einer Variante, bei welcher der zweite Wärmetauscher als Verflüssiger ausgebildet ist, ist vorgesehen, dass das Kältemittel in dem Verflüssiger kondensiert, so dass der Verflüssiger bei dieser Variante auch als Kondensator bezeichnet werden kann.

Für die im Stand der Technik grundsätzlich bekannten und als Wärmepumpen ausgebildeten Kraftwärmemaschinen gilt, dass das Kältemittel, welches beispielsweise Propangas oder ein anderes geeignetes Kältemittel ist, im Verdichter angetrieben durch einen Motor bzw. einen Kompressor zusammengepresst wird und sich dabei erhitzt. Das heiße, komprimierte Kältemittel kann dann in dem zweiten Wärmetauscher, welcher als Verflüssiger bzw. Kondensator ausgebildet sein kann oder einen solchen umfassen kann, seine Wärme an ein Zielsystem, wie beispielsweise eine Heizung, abgeben. Dabei kühlt sich das komprimierte Kältemittel ab und kondensiert. Beim anschließenden Durchgang durch die Drosselvorrichtung, welche meist als eine extreme Engstelle in der durch ein Rohr gebildeten Kältemittelleitung ausgebildet ist, wird das flüssige Kältemittel entspannt, verdampft dabei und wird sehr kalt. Anschließend lässt man das kalte Kältemittel dann durch den ersten Wärmetauscher strömen, welcher beispielsweise als Verdampfer ausgebildet ist oder einen solchen umfasst. Der erste Wärmetauscher bzw. das diesen durchströmende Kältemittel wird dabei von außen bzw. durch ein Ausgangssystem, beispielsweise durch Grundwasser oder die Außenluft, erwärmt, so dass sich das Kältemittel wieder erwärmt. Auf diese Weise, nimmt das Kältemittel aus dem Ausgangssystem, also z.B. dem Grundwasser oder der Außenluft, genauso viel Wärme auf, wie es vorher an das Zielsystem, beispielsweise die Heizung, abgegeben hat. Es wird dann wieder dem Verdichter zugeführt, und der Prozess beginnt von neuem.

Ferner umfasst die Kraftwärmemaschine erfindungsgemäß eine Elektronik insbesondere auch mit oder ohne eine zugehörige Leiterplatte, welche eine Leistungselektronik zur Stromversorgung und/oder eine Steuerungselektronik zur Steuerung und Kommutierung der Kraftwärmemaschine bzw. deren Komponenten umfasst. Dabei ist vorzugsweise vorgesehen, dass die Leistungselektronik zumindest einen Teil und vorzugsweise alle elektronischen Komponenten der Kraftwärmemaschine mit elektrischer Energie versorgt und diese entsprechend wandelt und dass die Steuerungselektronik zumindest einen Teil und vorzugweise alle Komponenten der Kraftwärmemaschine und insbesondere den Verdichter bzw. dessen Komponenten steuert, kommutiert und vorzugsweise regelt. Erfindungsgemäß ist zudem vorgesehen, dass die Kraftwärmemaschine ferner eine Wärmeübertragungsvorrichtung aufweist, welche ausgebildet ist, zumindest eine von der Elektronik abgegebene Wärmeenergie aufzunehmen und an das Kältemittel oder -sofern vorhanden - ein anderes in der Kraftwärmemaschine vorhandenes System-Medium abzugeben.

Die Elektronik, also die Leistungselektronik und/oder die Steuerungselektronik, gibt Wärmeenergie als Verlustwärme ab. Der Grundgedanke der Erfindung ist es daher, die Wärme durch gezielte Einwirkung dieser Wärmequellen auf die Wärmeübertragungsvorrichtung zu sammeln und konzentriert auf das Kältemittel und/oder - sofern vorhanden - ein System-Medium zu übertragen, wodurch ansonsten verlorene Wärme dem thermodynamischen Prozess zielgerichtet zugeführt und genutzt wird und zugleich die Elektronik gekühlt und deren Lebensdauer dadurch erhöht wird.

Betrachtet man hierzu beispielhaft marktübliche Wärmepumpensysteme, so liegt deren, nur bezüglich der Elektronik betrachtete Wirkungsgrad bei ca. 94%. Demnach entfaltet die erfindungsgemäße Kraftwärmemaschine ab einer elektrischen Leistung im kW-Bereich eine deutliche positive Wirkung. Hat ein solches System eine elektrische Leistung von beispielsweise 3,5 kW, fallen hiervon ca. 210 W in Form von Wärme als Verlustleistung ab. Diese Verlustleistung wird bei der erfindungsgemäßen Kraftwärmemaschine durch die Wärmeübertragungsvorrichtung gesammelt und konzentriert in das Kältemittel und/oder - sofern vorhaneden - in das System-Medium, also in den thermodynamischen Prozess, rück- bzw. eingespeist.

Bei größeren Systemen, beispielsweise mit einer elektrischen Leistung von 12 kW, kommt es bereits zu einer Verlustleistung von ca. 720 W, welche mit der erfindungsgemäßen Kraftwärmemaschine nicht verloren geht, sondern in den thermodynamischen Prozess rück- bzw. eingespeist wird.

Durch die vorgeschlagene erfindungsgemäße Kraftwärmemaschine kann sowohl bei einer als Kältemaschine als auch als Wärmpumpe ausgebildeten Variante die Leistungszahl erhöht werden, welche je nach Zusammenhang auch als "coefficient of performance" (COP) oder als "energy efficiency ratio" (EER) bezeichnet wird. Durch den zusätzlichen Wärmeeintrag kommt es entsprechend auch zu einer Steigerung der Effizienz durch die Verbesserung der Jahresarbeitszahl.

Neben der Verbesserung der Arbeitseffizienz können einzelne elektronische Komponenten aufgrund der verbesserten Kühlung auch kleiner dimensioniert werden, so dass es zu Kosteneinsparungen kommt. Zusätzlich wird durch die Kühlung mittels der Wärmeübertragungsvorrichtung auch die Lebensdauer der elektronischen Komponenten bzw. der Elektronik erhöht.

Die Elektronik bzw. deren Komponenten, deren Verlustwärme durch die Wärmeübertragungsvorrichtung aufgenommen und auf das Kältemittel und/oder - sofern vorhanden - auf das System-Medium übertragen wird, können einzelne aktive als auch passive elektronische Bauelemente, wie beispielsweise Drosseln, Kondensatoren, Leistungsmodule, MOSFETs, IGBTs, Dioden und weitere sein. Neben den einzelnen Bauelementen kann auch die Wärme bzw. Verlustwärme von elektronischen Baugruppen der Elektronik, wie beispielsweise einer Kommutierungselektronik eines Elektromotors, einer Motorsteuerung oder eines Frequenzumrichters von der Wärmeübertragungsvorrichtung aufgenommen und an das Kältemittel und/oder - sofern vorhanden - auf das System-Medium abgegeben werden.

Für eine vorteilhafte Übertragung der Wärme bzw. Verlustwärme von der Elektronik auf die Wärmeübertragungsvorrichtung ist bei einer vorteilhaften Weiterbildung vorgesehen, dass die Wärmeübertragungsvorrichtung ein beispielsweise aus Aluminium gebildeter Kühlkörper ist, welcher unmittelbar an der Elektronik bzw. deren Komponenten sowie an der Kältemittelleitung anliegt oder die Kältemittelleitung abschnittsweise ausbildet. Ferner ist der Kühlkörper ausgebildet, die aufgenommene Wärmeenergie auf das Kältemittel in der Kältemittelleitung abzugeben. Alternativ kann auch vorgesehen sein, dass die Wärmeübertragungsvorrichtung aus mehreren Kühlkörpern gebildet ist. Ferner ist möglich, dass die Wärmeübertragungsvorrichtung nicht an der Kältemittelleitung anliegt, sondern diese zumindest abschnittsweise bildet. Bei einer Variante der Kraftwärmemaschine, bei welcher diese ein System-Medium bzw. eine das System-Medium führende Leitung aufweist, kann zusätzlich oder alternativ vorgesehen sein, dass der Kühlkörper ferner an der das System-Medium führende und den zweiten Strömungspfad bestimmenden Leitung anliegt oder die Leitung abschnittweise ausbildet. Der Kühlkörper ist hierbei ausgebildet, die aufgenommene Wärmeenergie an das System-Medium abzugeben.

Eine weitere vorteilhafte Ausbildung sieht vor, dass die Wärmeübertragungsvorrichtung an einem von dem ersten Wärmetauscher, welcher als Verdampfer ausgebildet sein kann, zu dem Verdichter verlaufenden Abschnitt der Kältemittelleitung, also an der sogenannten Saugleitung, anliegt oder zumindest einen Teil dieses Abschnitts bildet. Wird die Wärmeübertragungsvorrichtung in Strömungsrichtung des Kältemittels so positioniert, dass der Wärmeeintrag durch die Wärmeübertragungsvorrichtung in das Kältemittel bzw. die Wärmeübertragung auf das Kältemittel nach dem ersten Wärmetauscher und vor dem Verdichter stattfindet, erhält das Kältemittel, welches nach dem Austreten aus dem ersten Wärmetauscher durch den Verdichter angesaugt wird, einen zusätzlichen Wärmeeintrag durch die Wärmeübertragungsvorrichtung, so dass das Kältemittel nach dem ersten Wärmetauscher nachverdampft wird. Dadurch wird möglicherweise noch flüssiges Kältemittel verdampft und der Verdichter vor einem solchen noch flüssigem Kältemittel geschützt, da es durch die Kompression von flüssigem Kältemittel in dem Verdichter zu einer Beschädigung des Verdichters kommen kann. Durch einen solchen Flüssigkeitskompressionsversuch kann es zum Teil zu einer Zerstörung bzw. Selbstzerstörung des Verdichters kommen.

Durch eine solche Positionierung der Wärmeübertragungsvorrichtung und die damit verbundene Nachverdampfung kann der Kältekreis bzw. die Wärmepumpe mit einer geringen Überhitzung von beispielsweise nahezu 0 Kelvin im Kältekreis bzw. im Kältemittel gefahren werden, wodurch das System auf einen höheren Effizienzlevel gehoben wird.

Für eine effiziente Übertragung der Wärme von der Elektronik auf das Kältemittel mittels der vorzugsweise als Kühlkörper ausgebildeten Wärmeübertragungsvorrichtung ist vorzugsweise ferner vorgesehen, dass die Kraftwärme.. maschine ferner eine Wärmeübertragungseinheit umfasst, in welcher die Elektronik und die Wärmeübertragungsvorrichtung integriert sind. Vorzugsweise ist die Elektronik und die Wärmeübertragungsvorrichtung entsprechend als eine Baugruppe ausgeführt, wobei diese beispielsweise von einem gemeinsamen Gehäuse gekapselt sein können.

Insbesondere bei einer Variante, bei welcher die Wärmeübertragungsvorrichtung zwischen dem ersten Wärmetauscher, welcher vorzugsweise als Verdampfer ausgebildet ist, und dem Verdichter vorgesehen ist, ist die Wärmeübertragungseinheit entsprechend vorzugsweise entlang der Kältemittelleitung zwischen dem ersten Wärmetauscher und dem Verdichter angeordnet. Die Kältemittelleitung kann hierbei auch die Wärmeübertragungseinheit durchlaufen.

Wie bereits zuvor ausgeführt, ist vorzugsweise vorgesehen, dass die Elektronik wärmeabgebende elektrische Komponenten bzw. elektrische Bauelemente oder Baugruppen aufweist. Zur Verbesserung der Wärmeübertragung von diesen Komponenten ist bei einer vorteilhaften Variante zudem vorgesehen, dass die Elektronik und/oder deren elektrische Komponenten zumindest abschnittsweise von der Wärmeübertragungsvorrichtung umschlossen sind. Darüber hinaus, kann die Elektronik bzw. können deren elektrische Komponenten in einer vorteilhaften Weiterbildung zumindest abschnittsweise in die Wärmeübertragungsvorrichtung eingebettet sein. Entsprechend kann die Wärmeübertragungsvorrichtung ausgebildet sein, die Elektronik bzw. zumindest einen Teil der Baugruppen oder Komponenten der Elektronik mehrseitig zu umgreifen.

Die elektrischen Komponenten, deren Abwärme bzw. deren Verlustwärme mittels der Wärmeübertragungsvorrichtung auf das Kältemittel übertragen wird, können sowohl aktive als auch passive elektrische Bauelemente und auch Baugruppen aus solchen elektrischen Bauelementen sein.

In einer vorteilhaften Weiterbildung kann die jeweilige Elektronik bzw. können die Baugruppen, welche die jeweilige Elektronik bilden, auch spezifisch auf die Wärmeübertragungsvorrichtung angepasst sein. Eine Kommutierungselektronik eines Elektromotors des Verdichters bzw. die Elektronik im Allgemeinen kann so aufgebaut sein, dass im Wesentlichen alle Leistungshalbleiter und passive elektrische Bauteile, wie z.B. eine PFC-Drossel in ihrer Positionierung unmittelbar benachbart zueinander angeordnet sind, so dass erfindungsgemäß die wärmeabgebenden elektrischen Komponenten in einem lokal begrenztem Bereich an die Wärmeübertragungsvorrichtung angrenzen bzw. an dieser anliegen.

Entsprechend sind an der Wärmeübertragungsvorrichtung vorzugsweise die Leistungskomponenten für eine Zwischenkreisaufbereitung und die Komponenten einer Kommutierungselektronik des Verdichtermotors positioniert, wobei zusätzlich weitere Komponenten anderer Baugruppen bzw. einer anderen Elektronik an die Wärmeübertragungsvorrichtung angrenzen können.

Da es bei dem Transport bzw. der Übertragung der Wärme von der Elektronik auf das Kältemittel nicht zu Verlusten an der Wärmeübertragungsvorrichtung kommen soll, kann diese zudem isoliert sein, so dass keine bzw. möglichst wenig Wärme nach außen abgegeben wird. Entsprechend ist es auch vorteilhaft die Wärmeübertragungsvorrichtung in einem lokal begrenzten Bereich vorzusehen.

Um die Wärme von der Elektronik auf das Kältemittel übertragen zu können, ist bei einer Ausführungsform, welche ebenfalls vorteilhaft ist, vorgesehen, dass die Wärmeübertragungsvorrichtung zumindest eine umfangsgeschlossene Ausnehmung aufweist. Die zumindest eine umfangsgeschlossene Ausnehmung ist von dem Kältemittel durchströmbar und bildet einen Abschnitt der Kältemittelleitung oder ist ausgebildet, einen Abschnitt der Kältemittelleitung aufzunehmen. Nimmt die umfangsgeschlossene Ausnehmung die Kältemittelleitung auf, ist ferner vorzugsweise vorgesehen, dass eine eventuell vorhandene Wärmeisolierung der Kältemittelleitung im Bereich der Wärmeübertragungsvorrichtung entfernt ist, so dass der Wärmeeintrag in das Kältemittel nicht behindert wird. In einer einfachen Ausführungsvariante, kann die umfangsgeschlossene Ausnehmung als eine Bohrung bzw. als ein Durchgang mit rundem oder quadratischem Querschnitt ausgebildet sein, welche bzw. welcher einen Kanal für das Kältemittel durch die Wärmeübertragungsvorrichtung bestimmt. Ist eine ein System-Medium führende Leitung vorhanden, kann vorgesehen sein, dass die umfangsgeschlossene Ausnehmung von dem System-Medium durchströmbar ist und einen Abschnitt der Leitung bildet oder ausgebildet ist, einen Abschnitt der das System-Medium führenden Leitung aufzunehmen. Entsprechend sind die weiteren Merkmale bezüglich der umfangsgeschlossenen Ausnehmung von der Kältemittelleitung auf die ein System-Medium führende Leitung übertragbar.

Alternativ aber auch zusätzlich zu einer umfangsgeschlossenen Ausnehmung, kann die Wärmeübertragungsvorrichtung bei einer Weiterbildung zumindest eine umfangsoffene Ausnehmung aufweisen. Die zumindest eine umfangsoffene Ausnehmung ist ausgebildet, die Kältemittelleitung abschnittsweise zu umfassen. Die zumindest eine umfangsoffene Ausnehmung kann entsprechend als eine Einprägung in die Wärmeübertragungsvorrichtung bzw. als eine Vorprägung in der Wärmeübertragungsvorrichtung ausgebildet sein, so dass beispielsweise ein die Kältemittelleitung bildendes Rohr in die Ausnehmung eingelegt werden kann. Eine eventuell vorhandene Wärmeisolierung der Kältemittelleitung ist vorzugsweise zumindest an dem Abschnitt der Kältemittelleitung entfernt, welcher an der Wärmeübertragungsvorrichtung anliegt, so dass der Wärmeeintrag über die Kältemittelleitung in das Kältemittel nicht behindert wird. Ist eine ein System-Medium führende Leitung vorhanden, kann entsprechend vorgesehen sein, dass die umfangsoffene Ausnehmung ausgebildet ist, die Leitung abschnittsweise zu umfassen. Entsprechend sind auch die weiteren Merkmale bezüglich der umfangsoffenen Ausnehmung von der Kältemittelleitung auf die ein System-Medium führende Leitung übertragbar.

Um die Strecke zu erhöhen, entlang welcher das Kältemittel durch die Wärmeübertragungsvorrichtung fließt, so dass entsprechend ein größerer Wärmeeintrag in das Kältemittel stattfinden kann, ist ferner vorzugsweise vorgesehen, dass sich die Kältemittelleitung bzw. in einer alternativen Ausführung die ein System-Medium führende Leitung mäanderförmig entlang und/oder durch die Wärmeübertragungsvorrichtung erstreckt oder im Bereich der Wärmeübertragungsvorrichtung mäanderförmig durch diese ausgebildet ist. Als mäanderförmig wird hierbei ein mehrere Kehren aufweisender Verlauf der jeweiligen Leitung verstanden.

Wird die Kältemittelleitung bzw. in einer alternativen Ausführung die ein System-Medium führende Leitung außerhalb oder auch durch die Wärmeübertragungsvorrichtung beispielsweise von einem Rohr- oder Schlauchsystem gebildet, ist an der Wärmeübertragungsvorrichtung eine Befestigungsvorrichtung zur Fixierung der Kältemittelleitung bzw. der jeweiligen Leitung vorgesehen, so dass diese an der Wärmeübertragungsvorrichtung ortsfest fixierbar ist. Diese Befestigungsvorrichtung ist beispielsweise als Flansch ausgebildet und/oder kann einen Schnellverschluss bzw. eine Schnellanschlusstechnik aufweisen, so dass beispielsweise ein Rohr oder Rohrsystem an oder in der Wärmeübertragungsvorrichtung fixierbar ist.

Zur weiteren Steigerung des Wirkungsgrades der Kraftwärmemaschine ist bei einer weiteren Ausbildungsvariante vorgesehen, dass diese ferner einen zusätzlichen Wärmetauscher aufweist, welcher an dem Verdichter bzw. einer wärmeabgebenden Komponente des Verdichters, wie beispielsweise einem Verdichtermotor, anliegt oder integral mit dem Verdichter bzw. einem Gehäuse des Verdichters ausgebildet ist. Ferner liegt der (zusätzliche) Wärmetauscher an der Kältemittelleitung oder - falls vorhanden - der das System-Medium führenden Leitung an oder bildet diese abschnittsweise. Der (zusätzliche) Wärmetauscher ist zudem ausgebildet, zumindest eine von dem Verdichter abgegebene Wärmeenergie aufzunehmen und an das Kältemittel bzw. das System-Medium abzugeben, also vom Verdichter auf das Kältemittel bzw. das System-Medium zu übertragen. Im Betrieb kann das Gehäuse eines Verdichters beispielsweise auf über 50°C erhitzt werden. Diese Wärme kann durch eine geeignete Wärmekopplung mittels des zusätzlichen Wärmetauschers in das Kältemittel bzw. das System-Medium überführt werden.

Der weitere Wärmetauscher kann beispielsweise durch eine Kupferspirale um den Verdichter, Aluminiumplatten oder dergleichen gebildet sein.

Auch hier ist vorzugsweise vorgesehen, dass der zusätzliche Wärmetauscher an der Kältemittelleitung in Strömungsrichtung vor dem Verdichter anliegt oder diese ausbildet, so dass es zu einem Nachverdampfen des Kältemittels kommt, bevor dieses in den Verdichter eintritt.

Die vorstehend offenbarten Merkmale sind beliebig kombinierbar, soweit dies technisch möglich ist und diese nicht im Widerspruch zueinander stehen.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt. Es zeigen:
- Fig. 1: eine schematische Darstellung einer Kraftwärmemaschine;
- Fig. 2: eine erste Variante einer Wärmeübertragungsvorrichtung;
- Fig. 3: eine zweite Variante einer Wärmeübertragungsvorrichtung;

Die Figuren sind beispielhaft schematisch. Gleiche Bezugszeichen in den Figuren weisen auf gleiche funktionale und/oder strukturelle Merkmale hin.

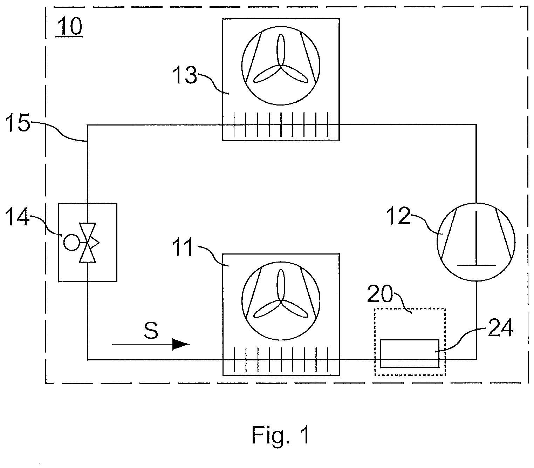

Figur 1 zeigt schematisch und beispielhaft die Komponenten sowie die Wirkverbindung der Komponenten einer Kraftwärmemaschine 10 bzw. die Kraftwärmemaschine 10. Diese weist beispielsweise einen Verdampfer als ersten Wärmetauscher 11, einen Verdichter bzw. Kompressor 12, beispielsweise einen Verflüssiger bzw. Kondensator als zweiten Wärmetauscher 13 und eine Drosselvorrichtung 14 auf, welche durch eine Kältemittelleitung 15 miteinander verbunden sind, durch welche ein Kältemittel entlang der Strömungsrichtung S strömt. Der erste Wärmetauscher 11 und der zweite Wärmetauscher 13 sind ferner beispielhaft als reine luftbeaufschlagte Lamellenwärmeübertrager dargestellt. Dabei findet in der Kraftwärmemaschine 10 der bekannte thermodynamische Prozess statt. Zur Steuerung der Kraftwärmemaschine 10 umfasst diese ferner eine Elektronik 21, 22, 23, welche jedoch in der Fig. 1 nicht dargestellt ist und beispielsweise Bestandteil der in Figur 1 dargestellten Komponenten der Kraftwärmemaschine 10 oder in eine Wärmeübertragungseinheit 20 integriert sein kann. Bei der Elektronik handelt es sich vorzugsweise um passive und aktive Elektronikkomponenten, wie Drosseln, Kondensatoren, Module, MOSFETs, IGBTs usw.

Ferner umfasst die Kraftwärmemaschine 10 eine Wärmeübertragungsvorrichtung 24, welche vorzugsweise und wie in Figur 1 dargestellt in die Wärmeübertragungseinheit 20 integriert ist, wobei die Wärmeübertragungsvorrichtdung 24 bzw. die Wärmeübertragungseinheit 20 entlang der Strömungsrichtung S des Kältemittels vorzugsweise zwischen dem ersten Wärmetauscher 11 und dem Verdichter 12 angeordnet ist, so dass möglicherweise noch flüssige Bestandteile des Kältemittels, welche in dem zweiten Wärmetauscher 11 nicht bzw. nicht vollständig verdampft wurden, nachverdampft werden und keine flüssigen Bestandteile des Kältemittels in den Verdichter 12 gelangen können, wodurch dieser vor Beschädigung geschützt wird.

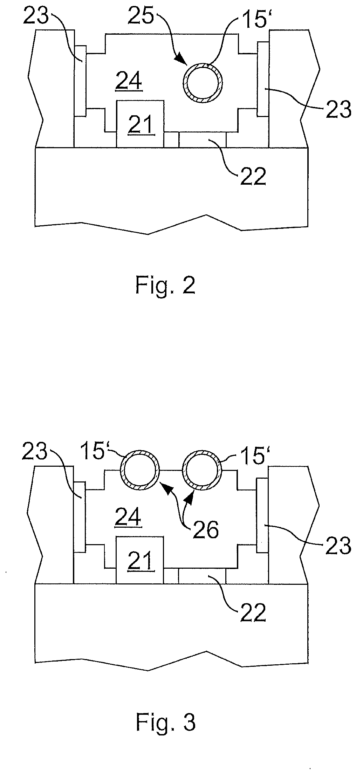

Die Figuren 2 und 3 zeigen jeweils eine Variante einer Wärmeübertragungsvorrichtung 24 mit umliegender Elektronik 21, 22, 23 bzw. umliegenden elektronischen Komponenten, wobei diese jeweils gemeinsam in eine Wärmeübertragungseinheit 20 integriert sein können.

Es ist jeweils eine erste Elektronik 21 mit oder ohne zugehöriger Leiterplatte vorgesehen, welche beispielsweise ein passives elektrisches Bauteil, eine PFC-Drossel, eine Zwischenkreis-Drossel, einen Buck-Converter oder mehrere solche Komponenten aufweisen kann. Ferner ist mit einer zweiten Elektronik 22 eine Leistungsendstufe einer Hauptkommutierung bzw. Verdichterkommutierung mit oder ohne zugehörige Leiterplatte vorgesehen. Zusätzlich kann eine dritte Elektronik 23 mit oder ohne zugehörige Leiterplatte vorgesehen sein, welche aus einer oder mehreren zusätzlichen Wärmequellen, wie beispielsweise weitere Leistungsendstufen für eine Ventilatorkommutierung von zu der Kraftwärmemaschine gehörenden Ventilatoren besteht. Die dritte Elektronik 23 bzw. deren Komponenten, können zudem nach dem Plug-In Prinzip eingesteckt und an der Wärmeübertragungsvorrichtung 24 zur Anlage gebracht werden.

Die Varianten gemäß den Figuren 2 und 3 unterscheiden sich im Wesentlichen dadurch, dass in der Ausführungsform gemäß Figur 1 eine umfangsgeschlossene Ausnehmung 25 vorgesehen ist, welche ausgebildet ist, abschnittsweise ein die Kältemittelleitung 15 oder alternativ eine das System-Medium führende Leitung bildendes Rohr 15' bzw. Rohrsystem aufzunehmen oder auszubilden.

Davon abweichend sind bei der Variante gemäß Figur 3 zwei umfangsoffene Ausnehmungen 26 vorgesehen, wobei auch lediglich eine umfangsoffene Ausnehmung 26 vorgesehen sein kann. Die umfangsoffenen Ausnehmungen 26 sind jeweils ausgebildet, das die Kältemittelleitung 15 bzw. die das System-Medium führende Leitung bildende Rohr 15' zumindest abschnittsweise zu umfassen.

Sowohl in der Variante gemäß der Figur 2 als auch gemäß der Figur 3 ist vorgesehen, dass die Wärmeübertragungsvorrichtung 24 die Wärme der Elektrik 21, 22, 23 aufnimmt und an das Kältemittel oder das System-Medium überträgt, welches das Rohr 15' bzw. die Wärmeübertragungsvorrichtung 24 durchfließt.

## Patentansprüche

1. Kraftwärmemaschine (10) mit einem ersten Wärmetauscher (11), einem Verdichter (12), einem zweiten Wärmetauscher (13) und einer Drosselvorrichtung (14), welche durch eine von einem Kältemittel durchströmten Kältemittelleitung (15) verbunden sind, sowie mit einer Elektronik (21, 22, 23), welche eine Leistungselektronik zur Stromversorgung und/oder eine Steuerungselektronik zur Steuerung der Kraftwärmemaschine (10) umfasst,
wobei die Kraftwärmemaschine (10) ferner eine Wärmeübertragungsvorrichtung (24) aufweist,
welche ausgebildet ist, zumindest eine von der Elektronik (21, 22, 23) abgegebene Wärmeenergie aufzunehmen und an das Kältemittel abzugeben,
wobei die Elektronik (21, 22, 23) wärmeabgebenden elektrischen Komponenten aufweist,
**dadurch gekennzeichnet, dass** die wärmeabgebenden elektrischen Komponenten unmittelbar benachbart zueinander angeordnet sind und in einem lokal begrenztem Bereich an der Wärmeübertragungsvorrichtung (24) anliegen, sodass die Wärmeenergie konzentriert auf das Kältemittel übertragen wird.

2. Kraftwärmemaschine nach Anspruch 1,
wobei die Wärmeübertragungsvorrichtung (24) ein Kühlkörper ist, welcher unmittelbar an der Elektronik (21, 22, 23) oder unmittelbar an wärmeabgebenden elektrischen Komponenten der Elektronik (21, 22, 23) sowie an der Kältemittelleitung (15) anliegt oder die Kältemittelleitung (15) abschnittsweise ausbildet,
und wobei der Kühlkörper ausgebildet ist, die aufgenommene Wärmeenergie an das Kältemittel in der Kältemittelleitung (15) abzugeben.

3. Kraftwärmemaschine nach einem der Ansprüche 1 oder 2,
wobei die Wärmeübertragungsvorrichtung (24) an einem von dem ersten Wärmetauscher (11) zu dem Verdichter (12) verlaufenden Abschnitt der Kältemittelleitung (15) anliegt oder zumindest einen Teil dieses Abschnitts bildet.

4. Kraftwärmemaschine nach einem der vorhergehenden Ansprüche,
ferner umfassend eine Wärmeübertragungseinheit (20), in welcher die Elektronik (21, 22, 23) und die Wärmeübertragungsvorrichtung (24) integriert sind.

5. Kraftwärmemaschine nach dem vorhergehenden Anspruch,
wobei die Wärmeübertragungseinheit (20) entlang der Kältemittelleitung (15) zwischen dem ersten Wärmetauscher (11) und dem Verdichter (12) angeordnet ist.

6. Kraftwärmemaschine nach einem der vorhergehenden Ansprüche,
und die Elektronik (21, 22, 23) und/oder deren elektrische Komponenten zumindest abschnittsweise von der Wärmeübertragungsvorrichtung (24) umschlossen sind.

7. Kraftwärmemaschine nach dem vorhergehenden Anspruch,
wobei die elektrischen Komponenten aktive und/oder passive elektrische Bauelemente sind.

8. Kraftwärmemaschine nach einem der vorhergehenden Ansprüche,
wobei die Wärmeübertragungsvorrichtung (24) zumindest eine umfangsgeschlossene Ausnehmung (25) aufweist
und die zumindest eine umfangsgeschlossene Ausnehmung (25) von dem Kältemittel durchströmbar ist und einen Abschnitt der Kältemittelleitung (15) bildet oder einen Abschnitt der Kältemittelleitung (15) aufnimmt.

9. Kraftwärmemaschine nach einem der vorhergehenden Ansprüche,
wobei die Wärmeübertragungsvorrichtung (24) zumindest eine umfangsoffene Ausnehmung (26) aufweist
und die zumindest eine umfangsoffene Ausnehmung (26) ausgebildet ist, die Kältemittelleitung (15) abschnittsweise zu umfassen.

10. Kraftwärmemaschine nach einem der vorhergehenden Ansprüche,
wobei sich die Kältemittelleitung (15) mäanderförmig entlang und/oder durch die Wärmeübertragungsvorrichtung (24) erstreckt oder abschnittsweise durch diese ausgebildet ist.

11. Kraftwärmemaschine nach einem der vorhergehenden Ansprüche,
wobei an der Wärmeübertragungsvorrichtung (24) eine Befestigungsvorrichtung zur Fixierung der Kältemittelleitung vorgesehen ist.

12. Kraftwärmemaschine nach einem der vorhergehenden Ansprüche,
ferner umfassend einen Wärmetauscher, welcher an dem Verdichter (12) anliegt oder integral mit diesem ausgebildet ist,
an der Kältemittelleitung (15) anliegt oder diese abschnittsweise bildet
und ausgebildet ist, zumindest eine von dem Verdichter (12) abgegebene Wärmeenergie aufzunehmen und an das Kältemittel abzugeben.

## Claims

1. A power heating machine (10) having a first heat exchanger (11), a compressor (12), a second heat exchanger (13), and a throttle device (14) which are connected by a refrigerant line (15) perfused by a refrigerant, as well as having electronics (21, 22, 23) which comprise power electronics for current supply and/or control electronics for controlling the power heating machine (10),
wherein the power heating machine (10) further has a heat transfer device (24)
which is embodied to absorb at least heat energy emitted from the electronics (21, 22, 23) and to emit it to the refrigerant,
wherein the electronics (21, 22, 23) have heat-emitting electrical components,
**characterised in that** the heat-emitting electrical components are arranged directly adjacent to one another and abut the heat transfer device (24) in a locally limited region, so that the heat energy is transferred to the refrigerant in a concentrated manner.

2. The power heating machine according to claim 1,
wherein the heat transfer device (24) is a heat sink which directly abuts the electronics (21, 22, 23) or directly abuts heat-emitting electrical components of the electronics (21, 22, 23) as well as the refrigerant line (15) or embodies portions of the refrigerant line (15),
and wherein the heat sink is embodied to emit the absorbed heat energy to the refrigerant in the refrigerant line (15).

3. The power heating machine according to any one of claims 1 or 2,
wherein the heat transfer device (24) abuts a portion of the refrigerant line (15) running from the first heat exchanger (11) to the compressor (12) or forms at least a part of this portion.

4. The power heating machine according to any one of the preceding claims,
further comprising a heat transfer unit (20) in which the electronics (21, 22, 23) and the heat transfer device (24) are integrated.

5. The power heating machine according to the preceding claim,
wherein the heat transfer unit (20) is arranged along the refrigerant line (15) between the first heat exchanger (11) and the compressor (12).

6. The power heating machine according to any one of the preceding claims,
and the electronics (21, 22, 23) and/or their electrical components are encompassed at least in portions by the heat transfer device (24).

7. The power heating machine according to the preceding claim,
wherein the electrical components are active and/or passive electrical structural elements.

8. The power heating machine according to any one of the preceding claims,
wherein the heat transfer device (24) has at least one circumferentially closed recess (25),
and the at least one circumferentially closed recess (25) is perfusable by the refrigerant and forms a portion of the refrigerant line (15) or receives a portion of the refrigerant line (15).

9. The power heating machine according to any one of the preceding claims,
wherein the heat transfer device (24) has at least one circumferentially open recess (26),
and the at least one circumferentially open recess (26) is embodied to comprise portions of the refrigerant line (15).

10. The power heating machine according to any one of the preceding claims,
wherein the refrigerant line (15) extends along and/or through the heat transfer device (24) in a serpentine shape or is embodied thereby in portions.

11. The power heating machine according to any one of the preceding claims,
wherein a fastening device for fixing the refrigerant line is provided on the heat transfer device (24).

12. The power heating machine according to any one of the preceding claims,
further comprising a heat exchanger which abuts the compressor (12) or is embodied integrally therewith,
abuts the refrigerant line (15) or forms it in portions,
and is embodied to absorb at least heat energy emitted from the compressor (12) and to emit it to the refrigerant.

## Revendications

1. Machine thermodynamique (10), comprenant un premier échangeur de chaleur (11), un compresseur (12), un deuxième échangeur de chaleur (13) et un dispositif d'étranglement (14), qui sont reliés par une conduite de fluide frigorigène (15) traversée par un fluide frigorigène, ainsi qu'une électronique (21, 22, 23) qui comprend une électronique de puissance pour l'alimentation en courant et/ou une électronique de commande pour commander la machine thermodynamique (10),
dans laquelle la machine thermodynamique (10) présente en outre un dispositif de transfert de chaleur (24),
qui est réalisé pour absorber au moins une énergie thermique dégagée par l'électronique (21, 22, 23) et pour la restituer au fluide frigorigène,
dans laquelle l'électronique (21, 22, 23) présente des composants électriques dégageant de la chaleur,
**caractérisée en ce que** les composants électriques dégageant de la chaleur sont agencés de manière directement voisine les uns des autres et sont adjacents au dispositif de transfert de chaleur (24) dans une zone localement délimitée de sorte que l'énergie thermique est transmise de manière concentrée au fluide frigorigène.

2. Machine thermodynamique selon la revendication 1,
dans laquelle le dispositif de transfert de chaleur (24) est un dissipateur de chaleur qui est directement adjacent à l'électronique (21, 22, 23) ou indirectement à des composants électriques dégageant de la chaleur de l'électronique (21, 22, 23) ainsi qu'à la conduite de fluide frigorigène (15) ou réalise la conduite de fluide frigorigène (15) par endroits,
et dans laquelle le dissipateur de chaleur est réalisé pour restituer l'énergie thermique absorbée au fluide frigorigène dans la conduite de fluide frigorigène (15).

3. Machine thermodynamique selon l'une quelconque des revendications 1 ou 2,
dans laquelle le dispositif de transfert de chaleur (24) est adjacent à une section de la conduite de fluide frigorigène (15) s'étendant du premier échangeur de chaleur (11) au compresseur (12) ou constitue au moins une partie de cette section.

4. Machine thermodynamique selon l'une quelconque des revendications précédentes,
comprenant en outre une unité de transfert de chaleur (20) dans laquelle sont intégrés l'électronique (21, 22, 23) et le dispositif de transfert de chaleur (24).

5. Machine thermodynamique selon la revendication précédente,
dans laquelle l'unité de transfert de chaleur (20) est agencée le long de la conduite de fluide frigorigène (15) entre le premier échangeur de chaleur (11) et le compresseur (12).

6. Machine thermodynamique selon l'une quelconque des revendications précédentes,
et l'électronique (21, 22, 23) et/ou ses composants électriques sont entourés du dispositif de transfert de chaleur (24) au moins par endroits.

7. Machine thermodynamique selon la revendication précédente,
dans laquelle les composants électriques sont des composants électriques actifs et/ou passifs.

8. Machine thermodynamique selon l'une quelconque des revendications précédentes,
dans laquelle le dispositif de transfert de chaleur (24) présente au moins un évidement (25) fermé en circonférence,
et ledit au moins un évidement (25) fermé en circonférence peut être traversé par le fluide frigorigène et constitue une section de la conduite de fluide frigorigène (15) ou reçoit une section de la conduite de fluide frigorigène (15).

9. Machine thermodynamique selon l'une quelconque des revendications précédentes,
dans laquelle le dispositif de transfert de chaleur (24) présente au moins un évidement (26) ouvert en circonférence,
et ledit au moins un évidement (26) ouvert en circonférence est réalisé pour entourer la conduite de fluide frigorigène (15) par endroits.

10. Machine thermodynamique selon l'une quelconque des revendications précédentes,
dans laquelle la conduite de fluide frigorigène (15) s'étend en forme de méandre le long du et/ou à travers le dispositif de transfert de chaleur (24) ou est par endroits réalisée par celui-ci.

11. Machine thermodynamique selon l'une quelconque des revendications précédentes,
dans laquelle un dispositif de fixation est prévu sur le dispositif de transfert de chaleur (24) pour fixer la conduite de fluide frigorigène.

12. Machine thermodynamique selon l'une quelconque des revendications précédentes,
comprenant en outre un échangeur de chaleur qui est adjacent au compresseur (12) ou est réalisé de manière intégrale avec celui-ci,
qui est adjacent à la conduite de fluide frigorigène (15) ou la constitue par endroits,
et qui est réalisé pour absorber au moins une énergie thermique dégagée par le compresseur (12) et pour la restituer au fluide frigorigène.
